# EUROPEAN PATENT APPLICATION

(11) **EP 4 598 330 A1**
(43) Date of publication of application: **06.08.2025**
(21) Application number: 22960760.1
(22) Date of filing: 26.09.2022
(51) Int. Cl.: H10N 60/12, H10N 60/01

(54) **QUANTUM DEVICE, QUANTUM COMPUTER, AND METHOD FOR MANUFACTURING QUANTUM DEVICE**

(71) Applicant: FUJITSU LIMITED, Kawasaki-shi, Kanagawa 211-8588 (JP)
(72) Inventor: HIROSE, Shinichi, Kawasaki-shi, Kanagawa 211-8588 (JP); KOUMA, Norinao, Kawasaki-shi, Kanagawa 211-8588 (JP)
(74) Representative: Hoffmann Eitle
(86) International application number: PCT/JP2022/035697
(87) International publication number: WO 2024/069696

(57) **Abstract**

A quantum device includes a substrate, a first superconductor layer provided on the substrate, and a first wiring line electrically coupled to the first superconductor layer, in which the first superconductor layer includes a first lower surface that has contact with the substrate, a first side surface that is continuous with the first lower surface, and a first upper surface that is continuous with the first side surface, the first side surface includes a first plane that is continuous with the first upper surface and a first curved surface that is continuous with the first plane and the first lower surface, a curvature center of the first curved surface is on a side of the first superconductor layer as viewed from the first curved surface, and the first wiring line has contact with the first upper surface and the first plane.

## Description

### TECHNICAL FIELD

The present disclosure relates to a quantum device, a quantum arithmetic device, and a method for manufacturing the quantum device.

### BACKGROUND ART

A quantum arithmetic device such as a quantum computer, using a superconductor has been known. In the quantum arithmetic device using the superconductor, a qubit, a signal reading unit, a filter unit, a resonator, and the like are formed using a superconductor layer formed on a substrate. At the time of use, the qubit, the signal reading unit, the filter unit, the resonator, and the like are cooled to a cryogenic temperature by a dilution refrigerator or the like.

### CITATION LIST

### PATENT DOCUMENT

Patent Document 1: U.S. Patent Application Publication No. 2020/0328338
Patent Document 2: U.S. Patent Application Publication No. 2017/0084813
Patent Document 3: Japanese Laid-open Patent Publication No. 2008-218439
Patent Document 4: Japanese Laid-open Patent Publication No. 61-42179

### SUMMARY OF INVENTION

### TECHNICAL PROBLEM

In a quantum arithmetic device, an electric field tends to concentrate in the vicinity of a boundary between a side surface of a superconductor layer and an upper surface of a substrate. When the electric field concentration occurs in the superconductor layer, de-coherence easily occurs. Furthermore, by only simply changing a shape of the superconductor layer to alleviate the electric field concentration, there is a possibility that disconnection of a wiring line coupled to the superconductor layer occurs.

An object of the present disclosure is to provide a quantum device capable of alleviating electric field concentration in a superconductor layer, while suppressing disconnection of a wiring line, a quantum arithmetic device, and a method for manufacturing the quantum device.

### SOLUTION TO PROBLEM

According to one aspect of the present disclosure, a quantum device is provided that includes a substrate, a first superconductor layer provided on the substrate, and a first wiring line electrically coupled to the first superconductor layer, in which the first superconductor layer includes a first lower surface that has contact with the substrate, a first side surface that is continuous with the first lower surface, and a first upper surface that is continuous with the first side surface, the first side surface includes a first plane that is continuous with the first upper surface and a first curved surface that is continuous with the first plane and the first lower surface, a curvature center of the first curved surface is on a side of the first superconductor layer as viewed from the first curved surface, and the first wiring line has contact with the first upper surface and the first plane.

### ADVANTAGEOUS EFFECTS OF INVENTION

According to the present disclosure, it is possible to alleviate electric field concentration in a superconductor layer while suppressing disconnection of a wiring line.

### BRIEF DESCRIPTION OF DRAWINGS

FIG. 1 is a plan view illustrating a quantum device according to a first embodiment.
FIG. 2 is a cross-sectional view illustrating the quantum device according to the first embodiment.
FIG. 3 is a cross-sectional view (part 1) illustrating a first example of a method for manufacturing the quantum device according to the first embodiment.
FIG. 4 is a cross-sectional view (part 2) illustrating the first example of the method for manufacturing the quantum device according to the first embodiment.
FIG. 5 is a cross-sectional view (part 3) illustrating the first example of the method for manufacturing the quantum device according to the first embodiment.
FIG. 6 is a cross-sectional view (part 4) illustrating the first example of the method for manufacturing the quantum device according to the first embodiment.
FIG. 7 is a cross-sectional view (part 5) illustrating the first example of the method for manufacturing the quantum device according to the first embodiment.
FIG. 8 is a cross-sectional view (part 6) illustrating the first example of the method for manufacturing the quantum device according to the first embodiment.
FIG. 9 is a cross-sectional view (part 7) illustrating the first example of the method for manufacturing the quantum device according to the first embodiment.
FIG. 10 is a plan view (part 1) illustrating the first example of the method for manufacturing the quantum device according to the first embodiment.
FIG. 11 is a plan view (part 2) illustrating the first example of the method for manufacturing the quantum device according to the first embodiment.
FIG. 12 is a plan view (part 3) illustrating the first example of the method for manufacturing the quantum device according to the first embodiment.
FIG. 13 is a cross-sectional view (part 1) illustrating a second example of the method for manufacturing the quantum device according to the first embodiment.
FIG. 14 is a cross-sectional view (part 2) illustrating the second example of the method for manufacturing the quantum device according to the first embodiment.
FIG. 15 is a cross-sectional view (part 3) illustrating the second example of the method for manufacturing the quantum device according to the first embodiment.
FIG. 16 is a cross-sectional view (part 4) illustrating the second example of the method for manufacturing the quantum device according to the first embodiment.
FIG. 17 is a cross-sectional view (part 5) illustrating the second example of the method for manufacturing the quantum device according to the first embodiment.
FIG. 18 is a cross-sectional view (part 6) illustrating the second example of the method for manufacturing the quantum device according to the first embodiment.
FIG. 19 is a diagram illustrating a quantum arithmetic device according to a second embodiment.

### DESCRIPTION OF EMBODIMENTS

Hereinafter, embodiments of the present disclosure will be specifically described with reference to the accompanying drawings. Note that, in the present description and the drawings, components having substantially the same functional configuration will be denoted by the same reference sign, and redundant explanation may be omitted.

### (First Embodiment)

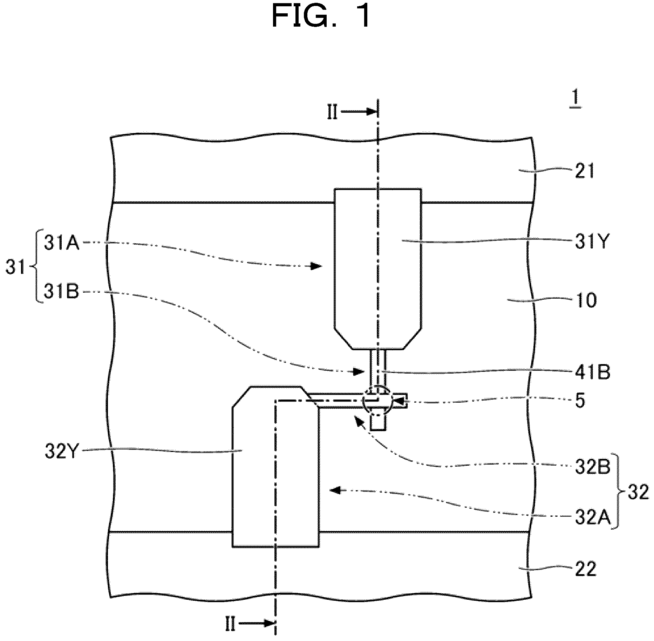

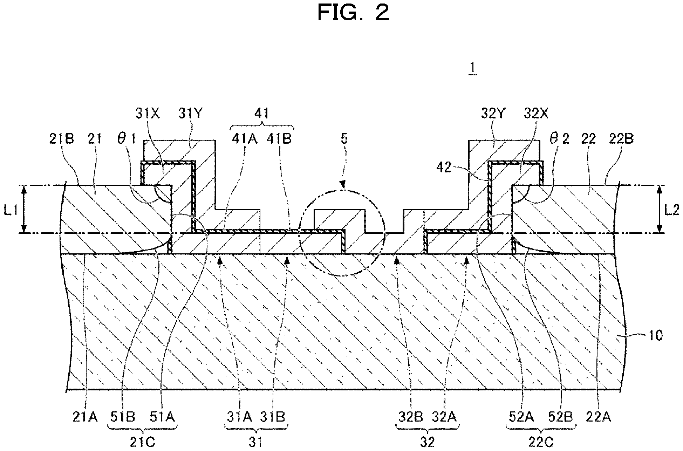

A first embodiment will be described. The first embodiment relates to a quantum device. FIG. 1 is a plan view illustrating the quantum device according to the first embodiment. FIG. 2 is a cross-sectional view illustrating the quantum device according to the first embodiment. FIG. 2 corresponds to a cross-sectional view taken along a line II-II in FIG. 1.

As illustrated in FIGs. 1 and 2, a quantum device 1 according to the first embodiment includes a substrate 10, a first superconductor layer 21, a second superconductor layer 22, a first wiring line 31, and a second wiring line 32.

The substrate 10 is, for example, a silicon substrate. The first superconductor layer 21 and the second superconductor layer 22 are provided on the substrate 10. The first superconductor layer 21 and the second superconductor layer 22 are separated from each other. Materials of the first superconductor layer 21 and the second superconductor layer 22 are, for example, niobium. Thicknesses of the first superconductor layer 21 and the second superconductor layer 22 are, for example, 200 nm.

The first superconductor layer 21 has a first lower surface 21A, a first upper surface 21B, and a first side surface 21C. The first lower surface 21A has contact with the substrate 10. The first side surface 21C is continuous with the first lower surface 21A. The first upper surface 21B is continuous with the first side surface 21C. The first lower surface 21A and the first upper surface 21B are, for example, planes parallel to each other. The first side surface 21C has a first plane 51A and a first curved surface 51B. The first plane 51A is continuous with the first upper surface 21B. The first curved surface 51B is continuous with the first plane 51A and the first lower surface 21A. A first interior angle θ1 of the first superconductor layer 21 at a boundary between the first upper surface 21B and the first plane 51A is, for example, equal to or more than 90 degrees, preferably equal to or more than 90 degrees and equal to or less than 100 degrees, and more preferably equal to or more than 90 degrees and equal to or less than 95 degrees. A curvature center of the first curved surface 51B is on a side of the first superconductor layer 21 as viewed from the first curved surface 51B. Therefore, the first curved surface 51B is a curved surface that protrudes outward. For example, a curvature of the first curved surface 51B continuously changes from the boundary with the first plane 51A to the boundary with the first lower surface 21A.

The second superconductor layer 22 has a second lower surface 22A, a second upper surface 22B, and a second side surface 22C. The second lower surface 22A has contact with the substrate 10. The second side surface 22C is continuous with the second lower surface 22A. The second upper surface 22B is continuous with the second side surface 22C. The second lower surface 22A and the second upper surface 22B are, for example, planes parallel to each other. The second side surface 22C has a second plane 52A and a second curved surface 52B. The second plane 52A is continuous with the second upper surface 22B. The second curved surface 52B is continuous with the second plane 52A and the second lower surface 22A. A second interior angle θ2 of the second superconductor layer 22 at a boundary between the second upper surface 22B and the second plane 52A is equal to or more than 90 degrees, preferably equal to or more than 90 degrees and equal to or less than 100 degrees, and more preferably equal to or more than 90 degrees and equal to or less than 95 degrees. A curvature center of the second curved surface 52B is on a side of the second superconductor layer 22 as viewed from the second curved surface 52B. Therefore, the second curved surface 52B is a curved surface that protrudes outward. For example, a curvature of the second curved surface 52B continuously changes from the boundary with the second plane 52A to the boundary with the second lower surface 22A.

The first wiring line 31 includes a base portion 31A and a fine wiring portion 31B. The base portion 31A has contact with the first upper surface 21B and the first plane 51A of the first superconductor layer 21. The first wiring line 31 is electrically coupled to the first superconductor layer 21. The base portion 31A has contact with the substrate 10. The base portion 31A has a substantially rectangular planar shape in plan view. When the planar shape of the base portion 31A is approximated to a rectangle, a length of the shortest side is several µm. The base portion 31A extends from the first superconductor layer 21 toward the second superconductor layer 22. The fine wiring portion 31B extends from an end of the base portion 31A on the side of the second superconductor layer 22 toward the second superconductor layer 22. When a planar shape of the fine wiring portion 31B is approximated to a rectangle, a length of the shortest side is several nm. The fine wiring portion 31B has contact with the substrate 10.

The first wiring line 31 includes a metal layer 31X and a metal layer 31Y. The metal layers 31X and 31Y include a superconductor such as aluminum. Each of thicknesses of the metal layers 31X and 31Y is, for example, several tens of nm. The metal layer 31X is provided over the base portion 31A and the fine wiring portion 31B. An insulator layer 41 is formed on a surface of the metal layer 31X, except for a portion having contact with the first superconductor layer 21. The insulator layer 41 includes a first region 41A and a second region 41B. The first region 41A covers a portion in the base portion 31A of the metal layer 31X. The second region 41B covers a portion in the fine wiring portion 31B of the metal layer 31X. The metal layer 31Y is provided on the first region 41A in the base portion 31A. A thickness of the insulator layer 41 is about several nm. In the base portion 31A, the first region 41A does not substantially electrically insulate the metal layer 31X and the metal layer 31Y, and the metal layer 31X and the metal layer 31Y are electrically coupled.

The second wiring line 32 includes a base portion 32A and a fine wiring portion 32B. The base portion 32A has contact with the second upper surface 22B and the second plane 52A of the second superconductor layer 22. The second wiring line 32 is electrically coupled to the second superconductor layer 22. The base portion 32A also has contact with the substrate 10. The base portion 32A has a substantially rectangular planar shape in plan view. When the planar shape of the base portion 32A is approximated to a rectangle, a length of the shortest side is several µm. The base portion 32A extends from the second superconductor layer 22 toward the first superconductor layer 21. The fine wiring portion 32B extends from the vicinity of an end of the base portion 32A on the side of the first superconductor layer 21 toward the fine wiring portion 31B of the first wiring line 31. The fine wiring portion 32B intersects with the fine wiring portion 31B in plan view. When a planar shape of the fine wiring portion 32B is approximated to a rectangle, a length of the shortest side is several nm. The fine wiring portion 32B has contact with the substrate 10.

The second wiring line 32 includes a metal layer 32X and a metal layer 32Y. The metal layers 32X and 32Y include a superconductor such as aluminum. Each of thicknesses of the metal layers 32X and 32Y is, for example, several tens of nm. The metal layer 32X is provided on the base portion 31A. On a surface of the metal layer 32X, an insulator layer 42 is formed, except for a portion having contact with the second superconductor layer 22. The metal layer 32Y is provided on the insulator layer 42 over the base portion 32A and the fine wiring portion 32B. A thickness of the insulator layer 42 is about several nm. The insulator layer 42 does not substantially electrically insulate the metal layer 32X and the metal layer 32Y, and the metal layer 32X and the metal layer 32Y are electrically coupled.

A portion of the fine wiring portion 32B intersecting with the fine wiring portion 31B in plan view is on the second region 41B of the insulator layer 41. That is, a portion of the second region 41B is provided between the fine wiring portion 31B of the first wiring line 31 and the fine wiring portion 32B of the second wiring line 32. Since portions of the fine wiring portion 31B and 32B facing each other via the second region 41B is minute, the fine wiring portion 31B and the fine wiring portion 32B are not electrically coupled, and a Josephson junction 5 is formed by the fine wiring portion 31B, the second region 41B of the insulator layer 41, and the fine wiring portion 32B.

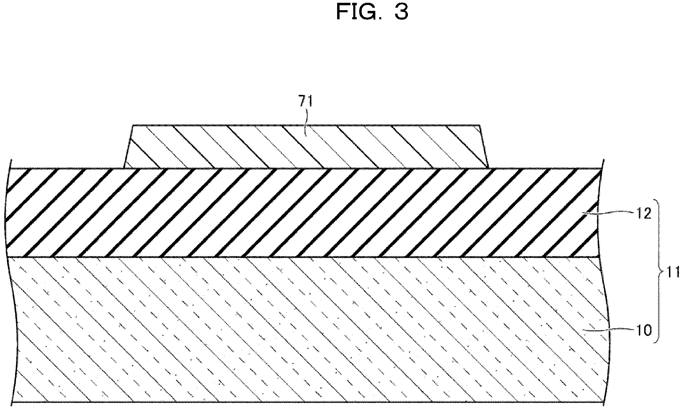

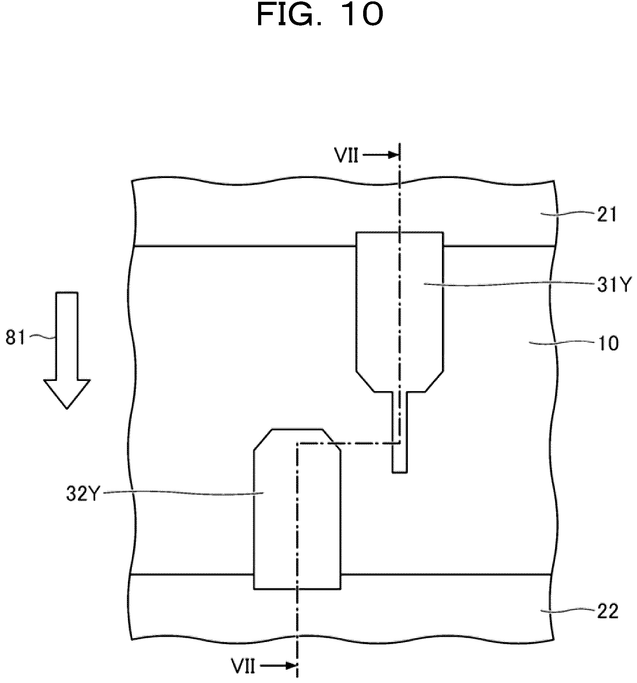

Next, a first example of a method for manufacturing the quantum device 1 according to the first embodiment will be described. FIGs. 3 to 9 are cross-sectional views illustrating the first example of the method for manufacturing the quantum device 1 according to the first embodiment. FIGs. 10 to 12 are plan views illustrating the first example of the method for manufacturing the quantum device 1 according to the first embodiment. FIGs. 3 to 9 illustrate a change in a cross section along the line II-II in FIG. 1.

First, as illustrated in FIG. 3, a substrate 11 is prepared. The substrate 11 includes the substrate 10 and a silicon oxide film 12. The substrate 11 is a so-called silicon substrate with an oxide film, and the silicon oxide film 12 is formed on the substrate 10. For example, the substrate 11 can be formed by thermal oxidation of the silicon substrate. As the substrate 11, a commercially available silicon substrate with an oxide film may be used. A thickness of the silicon oxide film 12 is, for example, 300 nm. The silicon oxide film 12 is an example of a sacrificial layer.

Next, a photoresist pattern 71 is formed on the silicon oxide film 12. A thickness of the pattern 71 is, for example, 700 nm. The pattern 71 can be formed by photolithography. The pattern 71 is formed to expose a region where the first superconductor layer 21 is formed and a region where the second superconductor layer 22 is formed. The pattern 71 is an example of a first mask.

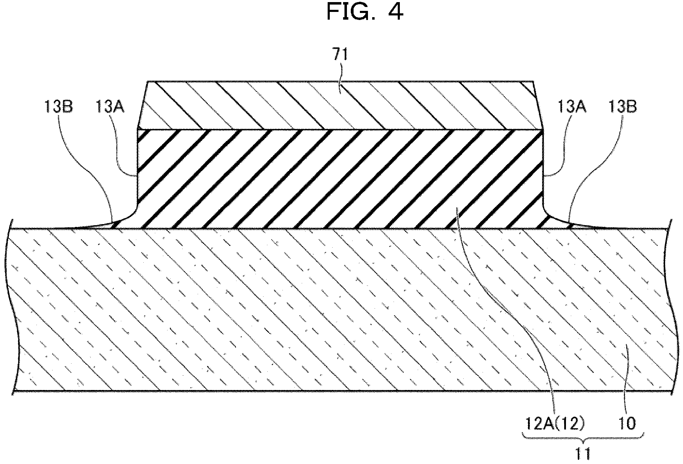

Thereafter, as illustrated in FIG. 4, the silicon oxide film 12 is processed with a thickness of 200 nm, by reactive ion etching (RIE) using the pattern 71 as an etching mask. In the RIE, for example, a parallel plate type RIE device is used, CF₄ gas is used as etching gas, a gas flow rate is set to 10 sccm, etching power is set to 300 W, and an etching pressure is set to 0.5 Pa. The RIE is performed from a direction perpendicular to an upper surface of the substrate 10, and a side surface of a portion covered with the pattern 71 is assumed as a plane perpendicular to the upper surface of the substrate 10. Furthermore, following the RIE, the silicon oxide film 12 is processed with a thickness of 100 nm, by wet etching using the pattern 71 as an etching mask. In the wet etching, a hydrofluoric acid solution having a concentration of five mass% is used as an etchant. By the wet etching, the upper surface of the substrate 10 is exposed. A side surface of a remainder 12A of the silicon oxide film 12 includes a third plane 13A perpendicular to the upper surface of the substrate 10 and a third curved surface 13B below the third plane 13A.

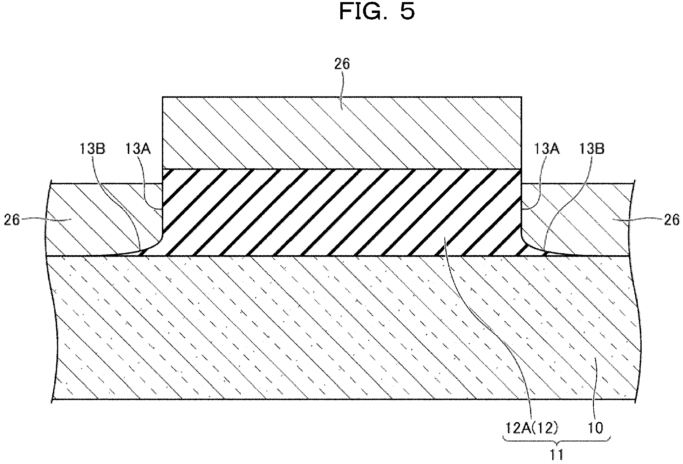

Subsequently, as illustrated in FIG. 5, the pattern 71 is removed. Next, a superconductor layer 26 thinner than the remainder 12A is formed on the substrate 10 and the remainder 12A of the silicon oxide film 12. A material of the superconductor layer 26 is, for example, niobium. A thickness of the superconductor layer 26 is, for example, 200 nm. The superconductor layer 26 can be formed, for example, by a sputtering method. In a case where the superconductor layer 26 is formed by the sputtering method, for example, a flow rate of argon gas is set to 20 sccm, a process pressure is set to 0.25 Pa, and a direct current (DC) current value is set to three A.

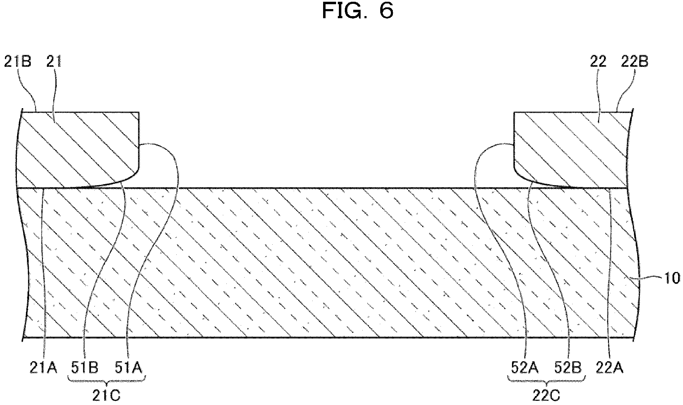

Next, as illustrated in FIG. 6, the remainder 12A of the silicon oxide film 12 is removed. The remainder 12A can be removed by using, for example, a hydrofluoric acid solution having concentration of five mass%. By removing the remainder 12A, the superconductor layer 26 on an upper surface of the remainder 12A is removed. As a result, the first superconductor layer 21 and the second superconductor layer 22 are formed. The first side surface 21C of the first superconductor layer 21 includes the first plane 51A along one third plane 13A and the first curved surface 51B along one third curved surface 13B. The second side surface 22C of the second superconductor layer 22 includes the second plane 52A along another third plane 13A and the second curved surface 52B along another third curved surface 13B.

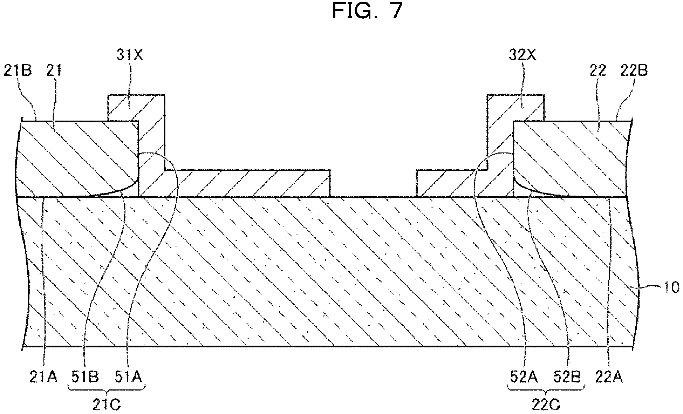

Thereafter, a lift-off film formation mask (not illustrated) used to form the first wiring line 31 and the second wiring line 32 is formed. The film formation mask has a two-layer structure including a polymer mask and a resist mask thereon. Then, as illustrated in FIGs. 7 and 10, the metal layers 31X and 32X are formed, by a vapor deposition method. When the metal layers 31X and 32X are formed, as illustrated in FIG. 10, a raw material 81 is supplied from a direction inclined from the direction perpendicular to the upper surface of the substrate 10. More specifically, the raw material 81 is supplied so that the raw material 81 flows from an end of the fine wiring portion 31B on the side of the base portion 31A toward an end on the side of the second superconductor layer 22 in plan view. In a case where the raw material 81 is supplied from such a direction, the raw material 81 does not reach a region where the fine wiring portion 32B of the second wiring line 32 is formed, and the metal layer is not formed. For example, a film formation speed of the metal layers 31X and 32X is set to 0.5 nm/second, and thicknesses of the metal layers 31X and 32X are set to several tens of nm. FIG. 7 corresponds to a cross-sectional view taken along a line VII-VII in FIG. 10.

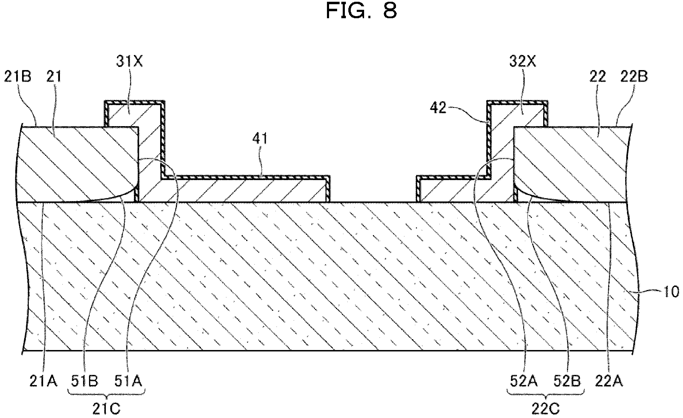

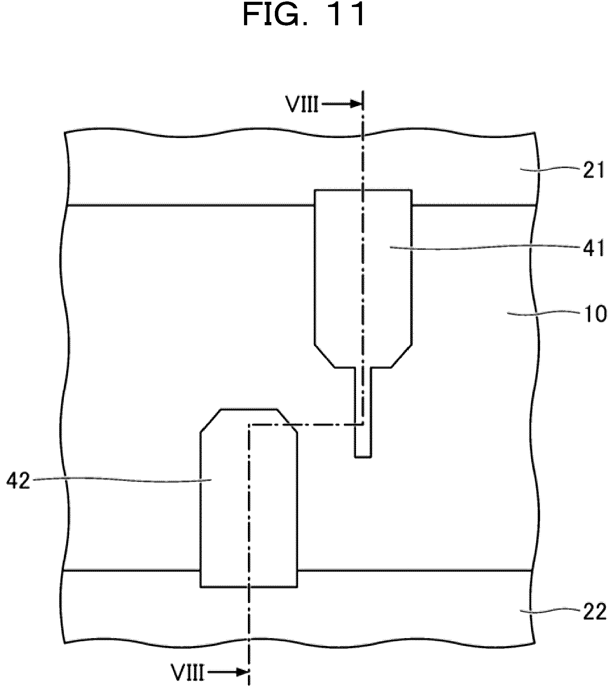

Subsequently, as illustrated in FIGs. 8 and 11, by oxidizing the surfaces of the metal layers 31X and 32X, the insulator layer 41 is formed on the surface of the metal layer 31X, and the insulator layer 42 is formed on the surface of the metal layer 32X. In the formation of the insulator layers 41 and 42, for example, a process pressure in a chamber of a vapor deposition device used to form the metal layers 31X and 32X is set to one Torr (about 133.32 Pa), and oxygen gas is supplied into the chamber. FIG. 8 corresponds to a cross-sectional view taken along a line VIII-VIII in FIG. 11.

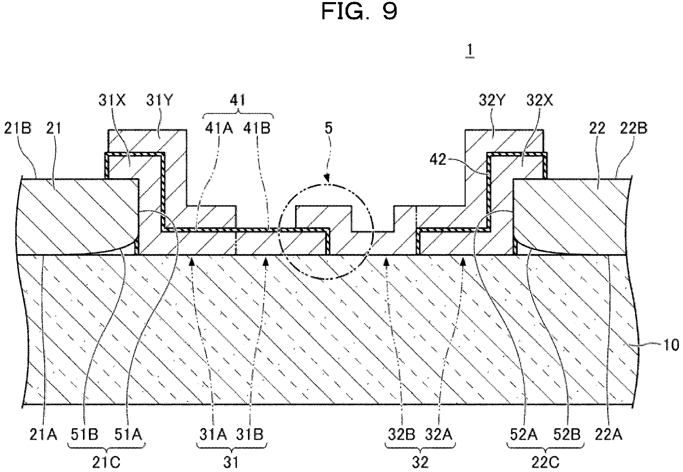

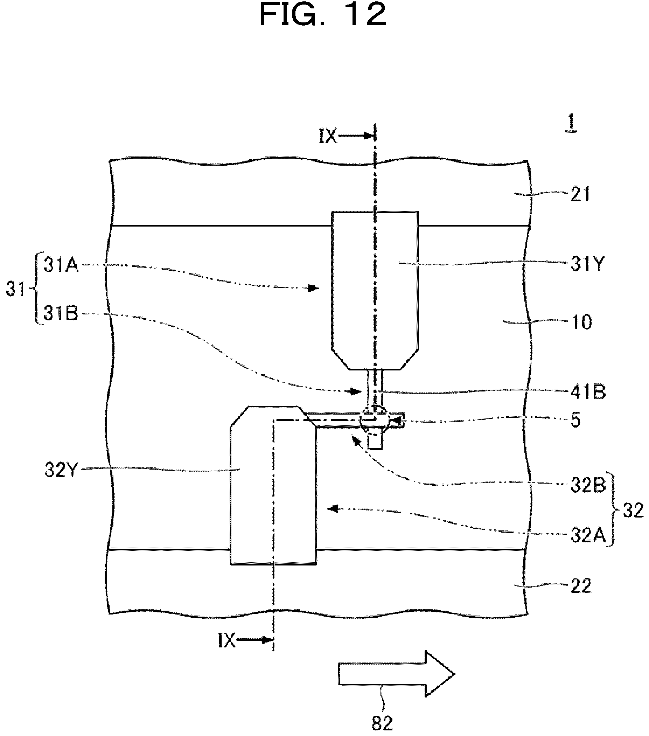

Next, as illustrated in FIGs. 9 and 12, the metal layers 31Y and 32Y are formed, by the vapor deposition method. When the metal layers 31Y and 32Y are formed, a raw material 82 is supplied from a direction inclined from the direction perpendicular to the upper surface of the substrate 10. More specifically, the raw material 82 is supplied so that the raw material 82 flows from an end of the fine wiring portion 32B on the side of the base portion 32A toward an end on the side of the fine wiring portion 31B, in plan view. In a case where the raw material 82 is supplied from such a direction, the raw material 82 does not reach a region where the fine wiring portion 31B of the first wiring line 31 is formed, and the metal layer is not formed. For example, a film formation speed of the metal layers 31Y and 32Y is set to 0.5 nm/second, and thicknesses of the metal layers 31Y and 32Y are set to several tens of nm. FIG. 9 corresponds to a cross-sectional view taken along a line IX-IX in FIG. 12.

Thereafter, the resist mask of the film formation mask is removed. Along with the removal of the resist mask, the metal layer formed on the resist mask is also removed. Subsequently, the polymer mask of the film formation mask is removed.

In this way, the quantum device 1 according to the first embodiment can be manufactured.

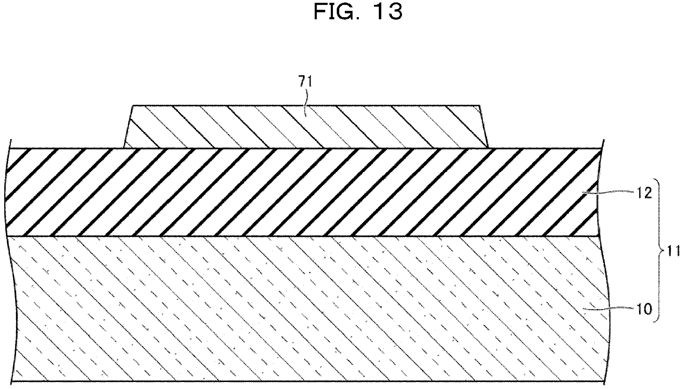

Next, a second example of the method for manufacturing the quantum device 1 according to the first embodiment will be described. FIGs. 13 to 18 are cross-sectional views illustrating the second example of the method for manufacturing the quantum device 1 according to the first embodiment. FIGs. 13 to 18 illustrate a change in a cross section taken along the line II-II in FIG. 1.

First, as illustrated in FIG. 13, the substrate 11 is prepared, as in the first example. The substrate 11 includes the substrate 10 and the silicon oxide film 12. The thickness of the silicon oxide film 12 is, for example, 300 nm. Next, the photoresist pattern 71 is formed on the silicon oxide film 12. The silicon oxide film 12 is an example of the sacrificial layer. The pattern 71 is an example of the first mask.

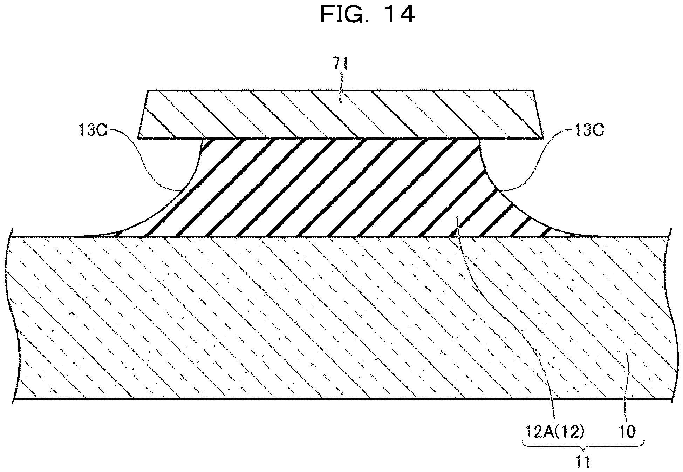

Thereafter, as illustrated in FIG. 14, the silicon oxide film 12 is processed with a thickness of 300 nm, by wet etching using the pattern 71 as an etching mask. In the wet etching, the hydrofluoric acid solution having the concentration of five mass% is used as an etchant. By the wet etching, the upper surface of the substrate 10 is exposed. The side surface of the remainder 12A of the silicon oxide film 12 has a fourth curved surface 13C.

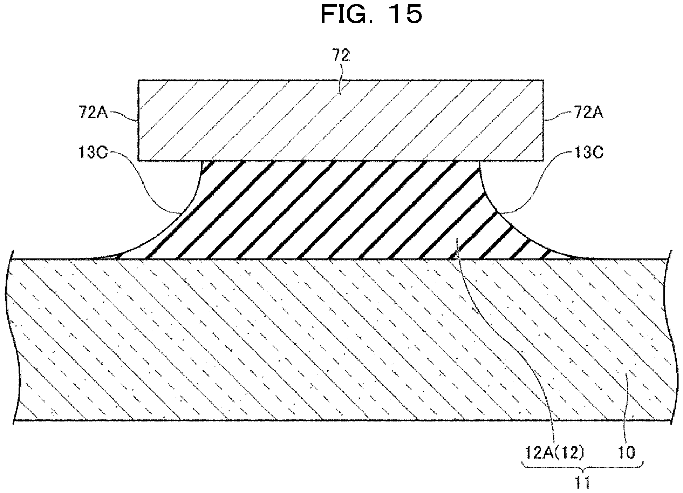

Subsequently, as illustrated in FIG. 15, the pattern 71 is removed. Next, a stencil mask 72 is formed on the remainder 12A of the silicon oxide film 12. The stencil mask 72 is formed to be wider than the remainder 12A in plan view. The stencil mask 72 is formed to expose a region where the first superconductor layer 21 is formed and a region where the second superconductor layer 22 is formed. The stencil mask 72 has side surfaces 72A perpendicular to the upper surface of the substrate 10. For example, an edge of the stencil mask 72 is positioned outside an edge of the upper surface of the remainder 12A by 150 nm, in plan view. A material of the stencil mask 72 is, for example, metal such as nickel. The stencil mask 72 is an example of a second mask.

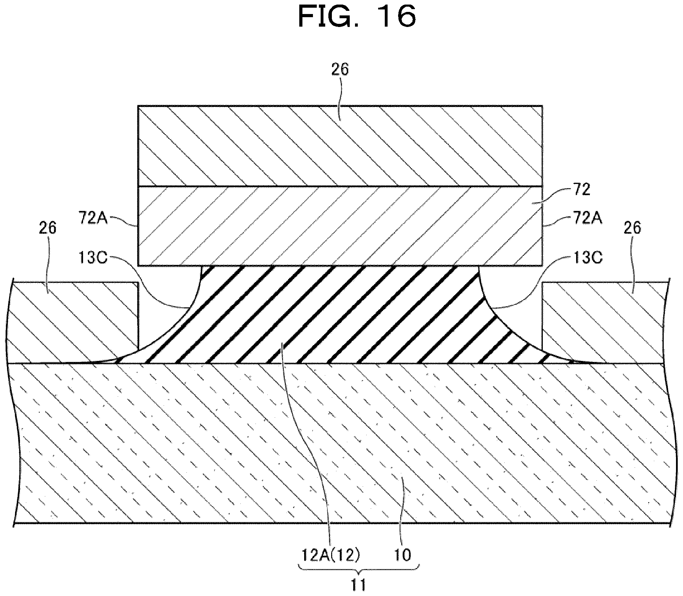

Thereafter, as illustrated in FIG. 16, the superconductor layer 26 thinner than the remainder 12A is formed on the substrate 10, the remainder 12A of the silicon oxide film 12, and the stencil mask 72. The thickness of the superconductor layer 26 is, for example, 200 nm.

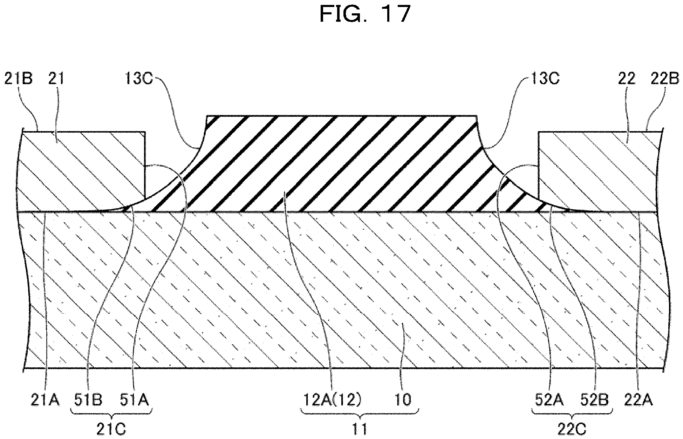

Subsequently, as illustrated in FIG. 17, the stencil mask 72 is removed. By removing the stencil mask 72, the superconductor layer 26 on the stencil mask 72 is removed. As a result, the first superconductor layer 21 and the second superconductor layer 22 are formed. The first side surface 21C of the first superconductor layer 21 includes the first plane 51A along the side surface 72A of the stencil mask 72 and the first curved surface 51B along one fourth curved surface 13C. The second side surface 22C of the second superconductor layer 22 includes the second plane 52A along the side surface 72A of the stencil mask 72 and the second curved surface 52B along another fourth curved surface 13C.

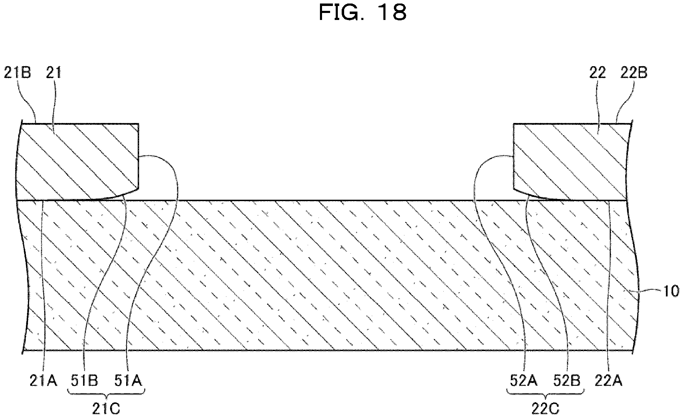

Next, as illustrated in FIG. 18, the remainder 12A of the silicon oxide film 12 is removed. The remainder 12A can be removed by using, for example, the hydrofluoric acid solution having the concentration of five mass%.

Thereafter, as in the first example, the first wiring line 31 and the second wiring line 32 are formed.

In this way, the quantum device 1 according to the first embodiment can be manufactured.

In the quantum device 1 according to the first embodiment, the first side surface 21C of the first superconductor layer 21 has the first plane 51A, and the first wiring line 31 has contact with the first upper surface 21B and the first plane 51A of the first superconductor layer 21. Furthermore, the first interior angle θ1 of the first superconductor layer 21 at the boundary between the first upper surface 21B and the first plane 51A is equal to or more than 90 degrees. When the first interior angle θ1 is less than 90 degrees, in the vicinity of the boundary between the first upper surface 21B and the first plane 51A, a large stress acts on the first wiring line 31, and there is a possibility that disconnection of the first wiring line 31 occurs. On the other hand, in the present embodiment, since the first interior angle θ1 is equal to or more than 90 degrees, the disconnection of the first wiring line 31 can be suppressed.

Furthermore, in a case where the first plane 51A reaches the upper surface of the substrate 10, in the vicinity of a lower end of the first plane 51A, electric field concentration easily occurs in the first superconductor layer 21. On the other hand, in the present embodiment, the first plane 51A does not reach the upper surface of the substrate 10, and the first curved surface 51B continuous with the first plane 51A reaches the upper surface of the substrate 10. Furthermore, the curvature center of the first curved surface 51B is on the side of the first superconductor layer 21 as viewed from the first curved surface 51B. Therefore, the electric field concentration in the first superconductor layer 21 can be alleviated.

In this way, according to the first embodiment, the electric field concentration in the first superconductor layer 21 can be alleviated, while suppressing the disconnection of the first wiring line 31. Similarly, the electric field concentration in the second superconductor layer 22 can be alleviated, while suppressing disconnection of the second wiring line 32.

Although the first interior angle θ1 is equal to or more than 90 degrees, as the first interior angle θ1 increases, the interior angle of the first superconductor layer 21 at the boundary between the first plane 51A and the first curved surface 51B decreases. In a case where the first interior angle θ1 is excessively large, there is a possibility that the disconnection of the first wiring line 31 occurs in the vicinity thereof. The first interior angle θ1 is preferably equal to or more than 90 degrees and equal to or less than 100 degrees and more preferably equal to or more than 90 degrees and equal to or less than 95 degrees. For the same reason, the second interior angle θ2 is preferably equal to or more than 90 degrees and equal to or less than 100 degrees and more preferably equal to or more than 90 degrees and equal to or less than 95 degrees.

Furthermore, in a case where a dimension L1 in a thickness direction of the first superconductor layer 21 of the first plane 51A is excessively small, a large stress is likely to act on the first wiring line 31 in the vicinity of the first plane 51A, and there is a possibility that disconnection occurs. The dimension L1 is preferably equal to or more than 50 nm and more preferably equal to or more than 100 nm. For the same reason, a dimension L2 in a thickness direction of the second superconductor layer 22 of the second plane 52A is preferably equal to or more than 50 nm and more preferably equal to or more than 100 nm.

Note that the quantum device 1 may include a filter, a resonator, or the like including the superconductor layer on the substrate 10. In this superconductor layer, the first superconductor layer 21 and the second superconductor layer 22 can be simultaneously formed, and similarly to the first superconductor layer 21 and the second superconductor layer 22, the side surface may include a plane and a curved surface.

Furthermore, in the method for manufacturing the quantum device 1, as the substrate 11, the commercially available silicon substrate with an oxide film may be used, or the substrate 11 may be formed by thermal oxidation of the silicon substrate.

### (Second Embodiment)

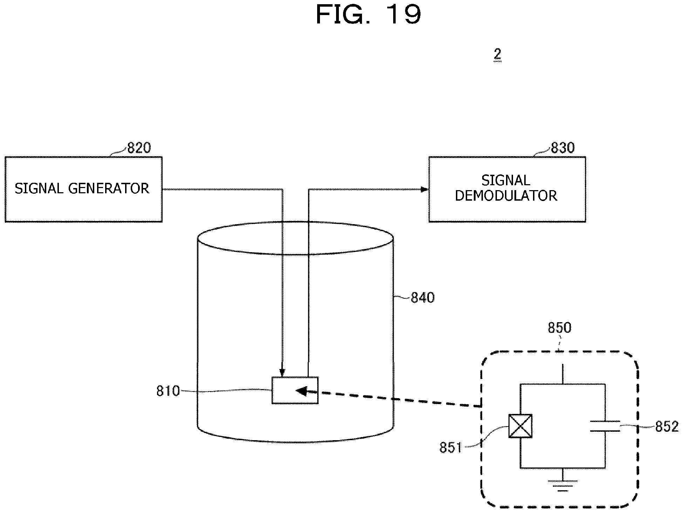

A second embodiment will be described. The second embodiment relates to a quantum arithmetic device including a Josephson device. FIG. 19 is a diagram illustrating the quantum arithmetic device according to the second embodiment.

As illustrated in FIG. 19, a quantum arithmetic device 2 according to the second embodiment includes a qubit chip 810, a signal generator 820, a signal demodulator 830, and a cryogenic dilution refrigerator 840. The qubit chip 810 is housed in the cryogenic dilution refrigerator 840, and is cooled to a temperature equal to or lower than 10 mK. The signal generator 820 generates a microwave pulse signal, and the microwave pulse signal is input to the qubit chip 810. The qubit chip 810 outputs a signal according to the microwave pulse signal, and the signal demodulator 830 demodulates the signal output from the qubit chip 810. The signal generator 820 and the signal demodulator 830 are used at, for example, a temperature of about room temperature.

The qubit chip 810 includes a plurality of superconducting qubits 850, and each superconducting qubit 850 includes a Josephson device 851 and a capacitor 852 electrically coupled in parallel to the Josephson device 851. The Josephson device 851 has a configuration similar to the quantum device 1 according to the first embodiment, includes a Josephson junction 5, and a first superconductor layer 21 and a second superconductor layer 22 are coupled to the capacitor 852. The qubit chip 810 may further include a filter, a resonator, or the like.

Since the Josephson device 851 included in the quantum arithmetic device 2 according to the second embodiment has the configuration similar to that of the quantum device 1, it is possible to alleviate electric field concentration in the superconductor layer while suppressing disconnection of a wiring line. Therefore, it is possible to suppress de-coherence and perform quantum calculation with excellent reliability.

Although the preferred embodiments and the like have been described in detail so far, the embodiments are not restricted to the above-described embodiments and the like, and various modifications and substitutions can be made to the embodiments and the like described above, without departing from the scope disclosed in the claims.

## Claims

1. A quantum device comprising:
a substrate;
a first superconductor layer provided on the substrate; and
a first wiring line electrically coupled to the first superconductor layer, wherein
the first superconductor layer includes
a first lower surface that has contact with the substrate,
a first side surface that is continuous with the first lower surface, and
a first upper surface that is continuous with the first side surface,
the first side surface includes
a first plane that is continuous with the first upper surface and
a first curved surface that is continuous with the first plane and the first lower surface,
a curvature center of the first curved surface is on a side of the first superconductor layer as viewed from the first curved surface, and
the first wiring line has contact with the first upper surface and the first plane.

2. The quantum device according to claim 1, wherein the first wiring line includes a superconductor.

3. The quantum device according to claim 2, wherein the first wiring line includes aluminum.

4. The quantum device according to any one of claims 1 to 3, wherein a first interior angle of the first superconductor layer at a boundary between the first upper surface and the first plane is equal to or more than 90 degrees and equal to or less than 100 degrees.

5. The quantum device according to any one of claims 1 to 3, further comprising:
a second superconductor layer provided on the substrate; and
a second wiring line electrically coupled to the second superconductor layer, wherein
the second superconductor layer includes
a second lower surface that has contact with the substrate,
a second side surface that is continuous with the second lower surface, and
a second upper surface that is continuous with the second side surface,
the second side surface includes
a second plane that is continuous with the second upper surface and
a second curved surface that is continuous with the second plane and the second lower surface,
a curvature center of the second curved surface is on a side of the second superconductor layer as viewed from the second curved surface,
the second wiring line has contact with the second upper surface and the second plane, and
the quantum device further comprises:
an insulator layer provided between the first wiring line and the second wiring line.

6. The quantum device according to claim 5, wherein the second wiring line includes a superconductor.

7. The quantum device according to claim 6, wherein the second wiring line includes aluminum.

8. The quantum device according to claim 5, wherein a second interior angle of the second superconductor layer at a boundary between the second upper surface and the second plane is equal to or more than 90 degrees and equal to or less than 100 degrees.

9. A quantum arithmetic device comprising: the quantum device according to claim 1 or 2.

10. A method for manufacturing a quantum device comprising:
a process of forming a first mask on a sacrificial layer provided on a substrate;
a process of forming a third curved surface that is continuous with an upper surface of the substrate and a third plane that is continuous with an upper surface of the sacrificial layer and the third curved surface, on a side surface of the sacrificial layer, by etching the sacrificial layer by using the first mask;
a process of removing the first mask, after the process of forming the third curved surface and the third plane;
a process of forming a third superconductor layer that is thinner than the sacrificial layer, on the substrate and the sacrificial layer;
a process of forming a first superconductor layer from the third superconductor layer formed on the substrate, by removing the sacrificial layer and the third superconductor layer on the upper surface of the sacrificial layer; and
a process of forming a first wiring line coupled to the first superconductor layer, after the process of removing the sacrificial layer and the third superconductor layer on the upper surface of the sacrificial layer, wherein
the first superconductor layer includes
a first lower surface that has contact with the substrate,
a first side surface that is continuous with the first lower surface, and
a first upper surface that is continuous with the first side surface,
the first side surface includes
a first plane that is continuous with the first upper surface, along the third plane and
a first curved surface that is continuous with the first plane and the first lower surface, along the third curved surface,
a curvature center of the first curved surface is on a side of the first superconductor layer as viewed from the first curved surface, and
the first wiring line has contact with the first upper surface and the first plane.

11. A method for manufacturing a quantum device, comprising:
a process of forming a first mask on a sacrificial layer provided on a substrate;
a process of forming a fourth curved surface that is continuous with an upper surface of the substrate, on a side surface of the sacrificial layer, by etching the sacrificial layer by using the first mask;
a process of removing the first mask, after the process of forming the fourth curved surface;
a process of forming a second mask on the sacrificial layer so that an edge of the second mask is positioned outside an edge of the sacrificial layer in plan view;
a process of forming a third superconductor layer that is thinner than the sacrificial layer, on the substrate and the second mask;
a process of forming a first superconductor layer from the third superconductor layer formed on the substrate, by removing the second mask and the third superconductor layer on an upper surface of the second mask;
a process of removing the sacrificial layer, after the process of forming the first superconductor layer; and
a process of forming a first wiring line coupled to the first superconductor layer, after the process of removing the sacrificial layer, wherein
the first superconductor layer includes
a first lower surface that has contact with the substrate,
a first side surface that is continuous with the first lower surface, and
a first upper surface that is continuous with the first side surface,
the first side surface includes
a first plane that is continuous with the first upper surface, along a side surface of the second mask and
a first curved surface that is continuous with the first plane and the first lower surface, along the fourth curved surface,
a curvature center of the first curved surface is on a side of the first superconductor layer as viewed from the first curved surface, and
the first wiring line has contact with the first upper surface and the first plane.
